# FASCICULE DE BREVET EUROPEEN

(11) **EP 3 061 180 B1**
(45) Date de publication et mention de la délivrance du brevet: **06.09.2017**
(21) Numéro de dépôt: 14824884.2
(22) Date de dépôt: 23.10.2014
(51) Int. Cl.: H02N 2/18, H01L 41/113

(54) **CONVERTISSEUR D'ENERGIE A RECUPERER ET GENERATEUR D'ELECTRICITE**
WANDLER ZUR UMWANDLUNG RÜCKZUGEWINNENDER ENERGIE UND STROMGENERATOR
CONVERTER FOR CONVERTING ENERGY TO BE RECOVERED AND ELECTRICITY GENERATOR

(30) Priorité: 25.10.2013 FR 1360433
(43) Date de publication de la demande: 31.08.2016
(73) Titulaire: Commissariat à l'Energie Atomique et aux Energies Alternatives, 75015 Paris (FR)
(72) Inventeur: VIALA, Bernard, F-38360 Sassenage (FR)
(74) Mandataire: Colombo, Michel
(86) Numéro de dépôt international: PCT/FR2014/052703
(87) Numéro de publication internationale: WO 2015/059418

(56) Documents cités:
- EP-A1- 2 501 031
- WO-A1-2006/046937
- WO-A1-2013/042505
- US-A1- 2009 315 335
- US-A1- 2012 119 620
- PING ET AL: "Effect of adjustable bias voltage on magnetoelectric properties of piezoelectric/magnetostrictive laminate transducer", ULTRASONICS SYMPOSIUM 2012 IEEE, 7 octobre 2012 (2012-10-07), pages 2510-2513, XP032434567, ISSN: 1948-5719, DOI: 10.1109/ULTSYM.2012.0628 ISBN: 978-1-4673-4561-3
- MINGSEN ET AL: "Annular bilayer magnetoelectric composites: theoretical analysis", IEEE TRANSACTIONS ON ULTRASONICS, FERROELECTRICS AND FREQUENCY CONTROL, vol. 57, no. 2, 1 février 2010 (2010-02-01), pages 480-489, XP011303284, ISSN: 0885-3010
- PING ET AL: "High efficiency passive magnetoelectric transducer consisting of PZT and Fe-Ni fork substrate with high Q value", SENSORS 2010 IEEE, 1 novembre 2010 (2010-11-01), pages 178-181, XP031978134, DOI: 10.1109/ICSENS.2010.5690689 ISBN: 978-1-4244-8170-5

## Description

L'invention concerne un convertisseur d'une variation d'énergie à récupérer en une différence de potentiels entre deux bornes de raccordement, la variation d'énergie à récupérer étant une variation de champ magnétique ou de température. L'invention concerne également un générateur d'électricité incorporant ce convertisseur.

Des convertisseurs connus d'électricité comportent :
- une membrane piézoélectrique présentant des faces intérieure et extérieure parallèles et au moins deux extrémités diamétralement opposées par rapport à un plan perpendiculaire à ses faces intérieure et extérieure, et passant par le centre de gravité de la membrane piézoélectrique,
- des première et seconde électrodes en matériau électriquement conducteur s'étendant essentiellement le long d'au moins une face de la membrane piézoélectrique pour faire apparaître un excédent de charges électriques sur l'une de ces électrodes en réponse à la déformation de la membrane piézoélectrique,
- une couche transductrice s'étendant entre des points d'ancrage, cette couche transductrice étant apte à transformer la variation d'énergie à récupérer en un déplacement mécanique des points d'ancrage les uns par rapport aux autres entre une position éloignée, dans laquelle les points d'ancrage sont éloignés les uns des autres, et une position rapprochée dans laquelle les points d'ancrage sont plus rapprochés les uns des autres, au moins l'un de ces points d'ancrage étant attaché à une extrémité de la membrane piézoélectrique pour déformer cette membrane piézoélectrique en flexion de façon réversible entre une position fléchie et une position moins fléchie lorsque ce point d'ancrage se déplace, l'amplitude du débattement maximal entre ses positions fléchie et moins fléchie étant supérieur à l'épaisseur de la membrane piézoélectrique.

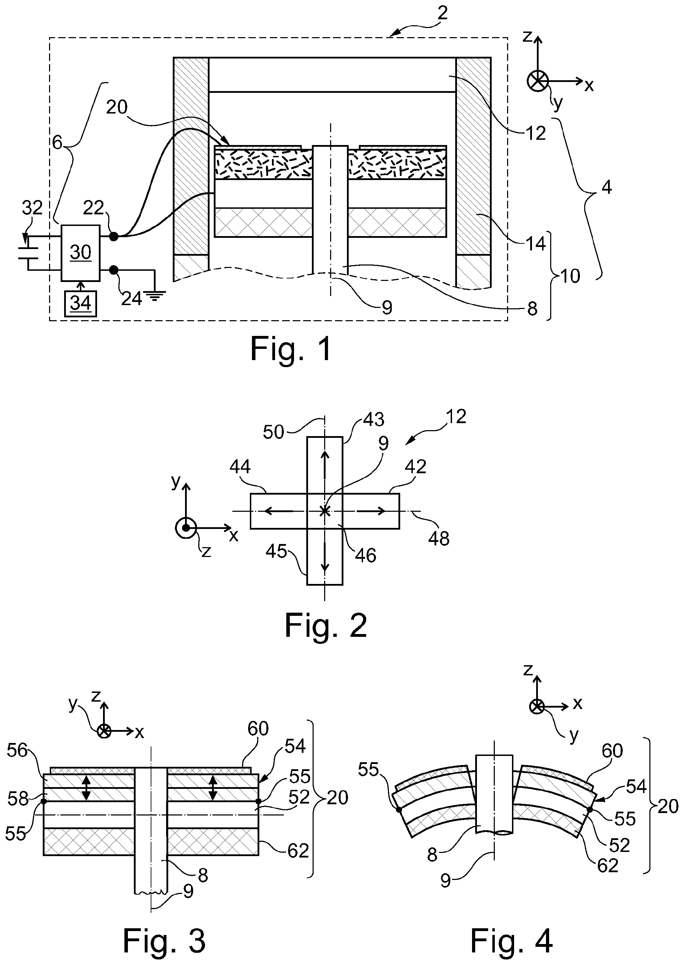

Un tel convertisseur, où la membrane travaille en flexion, est par exemple décrit en référence à la figure 3 de l'article A1 suivant : Zakharov, G. Lebedev, O. Cugat, J. Delamare, B. Viala, T. Lafont, L. Gimeno et A. Shelyakov, « Thermal energy conversion by coupled shape memory and piezoelectric effects », PowerMEMS'11, Séoul, Corée, JMM 2012.

Par la suite, on considère qu'une membrane piézoélectrique travaille en flexion si l'amplitude du débattement maximal entre ses positions fléchie et moins fléchie est supérieur à l'épaisseur de la membrane piézoélectrique et, de préférence, supérieur à dix, cent ou mille fois l'épaisseur de la membrane piézoélectrique.

Dans l'article A1, la membrane piézoélectrique se présente sous la forme d'une poutre dont l'une des extrémités est ancrée sans aucun degré de liberté dans un châssis tandis que l'extrémité diamétralement opposée est déplacée par un fil en matériau à mémoire de forme.

Dans un tel mode de réalisation, le fait que la membrane piézoélectrique travaille en flexion permet d'accroître l'efficacité du convertisseur par rapport à un mode de réalisation où elle travaillerait sans flexion. Un tel mode de réalisation sans déformation en flexion est décrit en référence à la figure 1 de l'article A1.

L'efficacité est ici définie comme étant la quantité d'énergie électrique produite en réponse à une même variation de l'énergie à récupérer.

De l'état de la technique est également connu de :
- US2009/315335A1,
- PING et Al : « Effect of adjustable bias voltage on magnetoelectric propertie of piezoelectric/magnetostrictive laminate transducer », Ultrasonic symposium 2012 IEEE, 7 octobre 2012, pages 2510-2513,
- MINGSEN et Al : « Annular bilayer magnetoelectric composites : theoritical analysis », IEEE Transactions on ultrasonics, Ferroelectric and frequency control », Vol. 57, N°2, 1 février 2010, pages 480-489,
- PING et Al : « Hig efficiency passive magnetoelectric transducer consisting of PZT and Fe-Ni fork substrate with high Q value », Sensors 2010 IEEE, 2010-11-01, pages 178-181,
- WO2013/042505A1.

L'invention vise à accroître encore plus l'efficacité d'un tel convertisseur.

Elle a donc pour objet un convertisseur conforme à la revendication 1.

Le fait de fixer les points d'ancrage à des extrémités de la membrane piézoélectrique diamétralement opposées permet d'exercer simultanément des efforts, en sens opposé de même amplitude, sur ces extrémités de la membrane piézoélectrique. Dans ces conditions, les contraintes mécaniques qui s'exercent sur les faces extérieure et intérieure de cette membrane sont beaucoup plus uniformément réparties. Cette uniformisation de la répartition des contraintes mécaniques permet de générer plus de charges électriques pour une même variation de l'énergie à récupérer que si l'une des extrémités de la membrane était ancrée sans aucun degré de liberté dans un châssis. Cela permet donc d'améliorer l'efficacité du convertisseur.

De plus, le fait de fixer les points d'ancrage aux extrémités de la membrane piézoélectrique permet d'obtenir une répartition uniforme des contraintes mécaniques sur les faces extérieure et intérieure de la membrane .

Le fait de fixer les extrémités de la membrane piézoélectrique sans aucun degré de liberté dans un châssis et de fixer les points d'ancrage au point milieu de cette membrane permet de déplacer ce point milieu perpendiculairement au plan de la membrane. Dans ces conditions, on obtient aussi une répartition uniforme des contraintes mécaniques sur les faces extérieure et intérieure de la membrane. Comme précédemment, cette uniformisation de la répartition des contraintes mécaniques dans la membrane piézoélectrique permet de générer plus de charges électriques en réponse à une même variation de l'énergie à récupérer, ce qui permet d'augmenter l'efficacité du convertisseur.

Enfin, l'utilisation d'un châssis et de bras pour attacher chaque points d'ancrage au point de fixation permet d'obtenir une déformation plus importante de la membrane que si la membrane était directement fixée sur la couche transductrice. De plus, cela rend possible d'avoir une membrane plane dans la position moins fléchie et donc d'éviter d'avoir à pré-contraindre cette membrane.

Les modes de réalisation de ce convertisseur peuvent comporter une ou plusieurs des caractéristiques des revendications dépendantes de convertisseur.

Ces modes de réalisation du convertisseur présentent en outre les avantages suivants :
- utiliser un ensemble de blocs en matériau à mémoire de forme dont la déformation est anisotrope permet d'augmenter l'amplitude des déplacements des points d'ancrage pour une même variation de température, et donc permet d'accroître encore plus l'efficacité du convertisseur par rapport au cas où la déformation de la couche transductrice serait isotrope ;
- utiliser plus de trois blocs permet de déformer simultanément la membrane piézoélectrique en flexion autour d'au moins deux axes différents, ce qui permet d'augmenter l'efficacité du convertisseur.

L'invention a également pour objet un générateur d'électricité conforme à la revendication indépendante de générateur.

Le fait d'utiliser simultanément plusieurs premiers blocs et plusieurs premières sources d'énergie à récupérer disposés les uns par rapport aux autres pour que dans la première position, les contraintes mécaniques exercées par chacun des premiers blocs soient simultanément maximales, permet d'augmenter la quantité de charges électriques générées par un déplacement du convertisseur par rapport au cas où le convertisseur comporte uniquement un seul bloc en matériau magnétostrictif ou à mémoire de forme. La seconde position permet d'alterner entre la première position où les contraintes mécaniques sont maximales et la seconde position où les contraintes mécaniques sont moindres ou de signe opposé. Grâce à cela, la différence de potentiels produite par le convertisseur varie au fur et à mesure que l'ensemble de sources d'énergie à récupérer alterne entre les première et seconde positions. Il est donc possible de produire de l'énergie électrique à chaque déplacement de l'ensemble par rapport au convertisseur à partir de source d'énergie à récupérer qui ne varient pas nécessairement au cours du temps. En absence de telles variations de la contrainte, la production d'énergie électrique serait impossible.

Les modes de réalisation de ce générateur peuvent comporter une ou plusieurs des caractéristiques des revendications dépendantes de générateur.

Ces modes de réalisation du générateur présentent en outre les avantages suivants :
- la présence des secondes sources de champ magnétique ou de seconds blocs en matériau magnétostrictif intercalés entre les premiers blocs, permet d'augmenter l'amplitude des déformations entre les première et seconde positions ce qui augmente l'efficacité du générateur,
- l'utilisation de sources locales de chaleur déplaçables entre les première et seconde positions permet de générer de l'énergie électrique même si la température des sources de chaleur ne varie pas.

L'invention sera mieux comprise à la lecture de la description qui va suivre, donnée uniquement à titre d'exemple non limitatif et faite en se référant aux dessins sur lesquels :
- la figure 1 est une illustration schématique, partiellement en coupe verticale, d'un générateur d'électricité,
- la figure 2 est une illustration, en vue de dessus, d'un ensemble d'aimants permanents utilisé dans le générateur de la figure 1,
- les figures 3 et 4 sont des illustrations schématiques, en coupe verticale, d'un convertisseur utilisé dans le générateur de la figure 1 dans, respectivement, une position moins fléchie et une position fléchie,
- la figure 5 est une illustration schématique, en vue de dessus, du convertisseur de la figure 3,
- la figure 6 est une illustration schématique, en vue de dessus, d'une couche transductrice utilisée dans le convertisseur de la figure 3,
- les figures 7, 8, et 9 sont des illustrations schématiques, en vue de dessus, de différents autres modes de réalisation de la couche transductrice de la figure 6 ;
- la figure 10 est une illustration schématique, en vue de dessus, d'un agencement d'un ensemble d'aimants permanents susceptible d'être utilisé à la place de l'agencement d'aimants permanents de la figure 2 dans le cas particulier de la couche transductrice de la figure 9 ;
- la figure 11 est une illustration schématique, en vue de dessus, d'un autre mode de réalisation du générateur de la figure 1 dans le cas d'un mouvement en translation ;
- les figures 12 à 17 sont des illustrations schématiques, en coupe verticale, de différents autres modes de réalisation possibles du convertisseur de la figure 3 ;
- la figure 18 est une illustration schématique et en vue de dessus d'un autre mode de réalisation d'une couche transductrice utilisable dans le convertisseur de la figure 3 pour récupérer une variation de température ;
- la figure 19 est une illustration schématique, en vue de dessus, d'un mode de réalisation d'une source d'énergie à récupérer produisant de la chaleur.

Dans ces figures, les mêmes références sont utilisées pour désigner les mêmes éléments.

Dans la suite de cette description, les caractéristiques et fonctions bien connues de l'homme du métier ne sont pas décrites en détail.

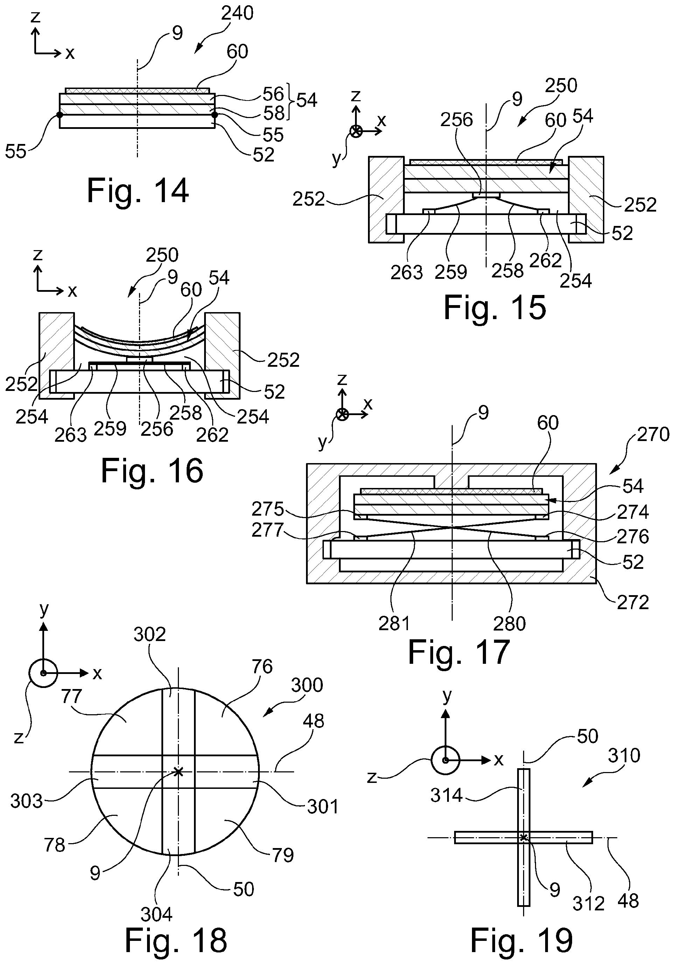

Les modes de réalisation décrits en référence aux figures 1 à 14 et 18 à 19 illustrent des modes de réalisation d'un convertisseur dépourvu de bras et qui ne sont donc pas protégés par la revendication 1 actuelle. Seules les figures 15 à 17 représentent des convertisseurs équipés de bras. Toutefois, des caractéristiques décrites en référence à ces figures 1 à 14 et 18 à 19 se retrouvent dans les modes de réalisation des figures 15 à 17 ou peuvent être combinées avec les caractéristiques des modes de réalisation des figures 15 à 17. Ainsi, les modes de réalisation des figures 1 à 14 et 18 à 19 sont utiles à la description des convertisseurs des figures 15 à 17.

La figure 1 représente un générateur 2 d'électricité. Ce générateur 2 comporte :
- une source 4 d'énergie à récupérer, et
- un récupérateur 6 d'énergie propre à transformer l'énergie à récupérer en énergie électrique.

Dans ce premier mode de réalisation, l'énergie à récupérer est une rotation d'un champ magnétique. Par exemple, le champ magnétique tourne autour d'un axe Z vertical d'un repère orthogonal X, Y, Z. Par la suite, chacune des figures est orientée par rapport à ce repère X, Y, Z.

Dans ce mode de réalisation, la source 4 comprend :
- un arbre 8 entraîné en rotation autour d'un axe vertical 9 et sur lequel est fixé sans aucun degré de liberté un convertisseur 20 du récupérateur 6 d'énergie, et
- un ensemble 12 de sources uni-axiales de champ magnétique fixé sans aucun degré de liberté sur un châssis 14 immobile à proximité du convertisseur 20.

L'arbre 8 est l'arbre d'un appareil 10. L'appareil 10 est par exemple un compteur liquide ou de gaz et l'arbre 8 est l'arbre de cet appareil entraîné en rotation lors du comptage du liquide ou du gaz consommé. Pour simplifier, seule une partie de l'appareil 10 est représentée.

Le récupérateur 6 d'énergie comporte :
- le convertisseur 20 qui convertit le champ magnétique tournant en un excédent correspondant de charges électriques sur une borne 22 ou 24 de raccordement par rapport à l'autre de ces bornes 22, 24.
- un circuit 30 de collecte de l'excédent de charges électriques sur la borne 22 ou 24 et de transfert de ces charges électriques collectées vers un élément électrique 32, et
- un circuit 34 de commande du circuit 30 de collecte.

L'élément 32 est un élément de stockage ou de consommation ou de transmission d'électricité. Il comporte un ou plusieurs composants électriques. Par exemple, l'élément 32 est un condensateur qui stocke l'énergie électrique récupérée.

Le circuit 30 de collecte et le circuit 34 de commande sont, par exemple, identiques à ceux décrits dans la demande WO 2007/063194 et, de préférence, identiques à l'un de ceux décrits dans la demande déposée sous le n° FR 1260047, le 22 octobre 2012 par le Commissariat à l'énergie atomique et aux énergies alternatives. Par conséquent, ces circuits 30 et 34 ne sont pas décrits ici plus en détail.

La figure 2 représente plus en détail l'ensemble 12. Ici, chaque source de champ magnétique de l'ensemble 12 correspond à un aimant permanent uni-axial. Par « uni-axial », on désigne le fait que chaque source présente un seul moment magnétique. Sur la figure 2 et les figures suivantes, le moment magnétique de chaque aimant permanent est représenté par une flèche. Toutefois, le sens dans lequel est dirigé ce moment magnétique n'a pas forcément d'importance car un matériau magnétostrictif n'est pas sensible au sens des lignes de champ. Les aimants permanents de l'ensemble 12 sont fixés les uns par rapport aux autres sans aucun degré de liberté de manière à ce que l'ensemble 12 présente simultanément et en permanence plusieurs moments magnétiques dont les projections orthogonales dans un plan horizontal sont décalées angulairement les unes par rapport aux autres autour de l'axe 9.

Ici, l'ensemble 12 comporte quatre aimants permanents 42 à 45. Sur la figure 2, les moments magnétiques des aimants 42 et 44 sont parallèles à la direction X et les moments magnétiques des aimants 43 et 45 sont parallèles à la direction Y. Plus précisément, dans la position représentée, les moments magnétiques des aimants 42 et 44 sont alignés au-dessus d'un axe horizontal 48 parallèle à la direction X et coupant l'axe 9. Dans le même temps, les moments magnétiques des aimants 43 et 45 sont alignés au-dessus d'un axe horizontal 50 parallèle à la direction Y et coupant l'axe 9. Les aimants 42 et 44 sont symétriques l'un de l'autre par rapport à un plan vertical passant par l'axe 50. De façon similaire, les aimants 43 et 45 sont symétriques l'un de l'autre par rapport à un plan vertical passant par l'axe 48. Ici, les aimants 42 à 45 sont disposés à chaque extrémité d'une croix. De plus, dans ce mode de réalisation, l'ensemble 12 comporte un aimant centrale 46 situé sur l'axe 9 et accolé aux pôles nord des aimants 42 à 45. Le moment magnétique de cet aimant 46 est vertical et situé sur l'axe 9. Il renforce les lignes de champ des aimants 42 à 45 vers le convertisseur 20.

Le convertisseur 20 va maintenant être décrit plus en détail en référence aux figures 3 à 6. Ce convertisseur 20 est capable de transformer en électricité des variations très lentes de l'énergie à récupérer. Par « variation lente », on désigne des variations dont la fréquence fondamentale est inférieure à 1 Hz ou 10 Hz. A cet effet, le convertisseur 20 convertit une variation de l'amplitude du champ magnétique variable dans une direction donnée en une génération d'un excédent de charges sur la borne 22 par rapport à la borne 24. Cette conversion se fait presque instantanément de sorte que la tension entre les bornes 22 et 24 varie en même temps et au fur et à mesure que l'amplitude du champ magnétique variable varie dans une direction donnée.

Dans ce mode de réalisation, le convertisseur 20 comporte une couche transductrice 52 qui déplace une membrane piézoélectrique 54 entre une position fléchie, représentée sur la figure 4, et une position moins fléchie représentée sur la figure 3. Dans ce mode de réalisation, en absence de champ magnétique extérieur, la la membrane 54 est dans sa position moins fléchie. Cette position est donc aussi appelée par la suite « position de repos ».

Dans la position de repos, la membrane 54 s'étend horizontalement sur toute la face du dessus de la couche 52. Dans ce mode de réalisation, elle présente une face intérieure directement fixée, sans aucun degré de liberté, sur cette face du dessus de la couche 52 par l'intermédiaire de points d'ancrage. Ici, la face intérieure est collée sur la majorité et, typiquement, plus de 90 % ou 98 % de la face du dessus de la couche 52. Dans ces conditions, le nombre de points d'ancrage est considéré comme infini. Pour simplifier la figure 3, seuls des points d'ancrage 55 situés sur la périphérie extérieure de la membrane 54 et de la couche 52 ont été représentés. C'est points d'ancrage 55 sont donc attachés à des extrémités respectives de la membrane 54. Ces extrémités sont les symétriques l'une de l'autre par rapport à l'axe 9. L'axe 9 passe par le centre de gravité de la membrane 54 et de la couche 52. Ici, les points d'ancrage 55 sont directement attachés sur ces extrémités par exemple par collage direct de la couche 52 sur la membrane 54 soit par l'intermédiaire d'une couche de colle. Dans la position de repos, ces points d'ancrage 55 sont plus éloignés les uns des autres que dans la position fléchie. Par la suite, on dit que les points 55 sont dans des positions éloignée et rapprochée lorsque la membrane 54 est dans ses positions, respectivement, de repos et fléchie.

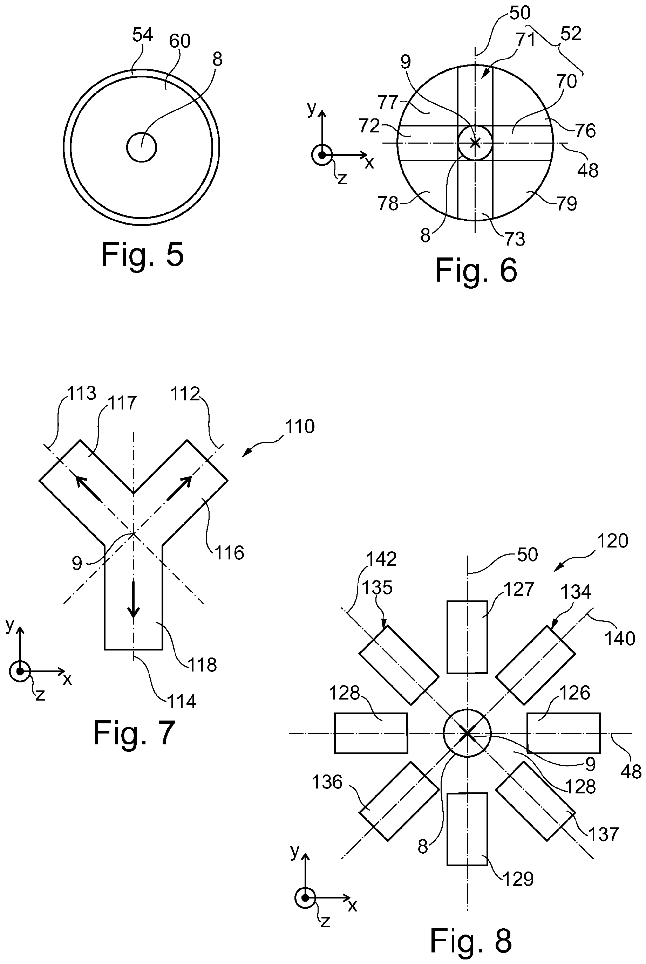

Dans la position de repos, la membrane 54 s'étend uniformément dans chaque direction horizontale. Par exemple, dans ce mode de réalisation, la membrane 54 a la forme d'un disque horizontal traversé en son centre par l'arbre 8 (figure 5).

La membrane 54 comporte également une face extérieure horizontale située du côté opposé à la face intérieure.

Lors de son fonctionnement, la membrane 54 génère un excédent de charges électriques sur ses faces extérieure et intérieure quand elle est dans sa position fléchie. Ce mode de fonctionnement est connu sous le terme de mode d₃₁. Dans ce mode de fonctionnement, la capacité de la membrane 54 est importante, ce qui améliore et facilite le fonctionnement du convertisseur 20. Typiquement, ce mode de fonctionnement de la membrane 54 est obtenu avec un matériau piézoélectrique polarisé parallèlement à son épaisseur.

Plus précisément, ici la membrane 54 est formée par la superposition de deux couches 56, 58 l'une au-dessus de l'autre dans la direction verticale. Typiquement, ces couches 56 et 58 sont réalisées dans le même matériau piézoélectrique sauf qu'elles sont polarisées verticalement en sens inverse l'une de l'autre. La direction de polarisation des couches 56 et 58 sont représentées par des flèches en gras à l'intérieur de ces couches sur la figure 3. Ici, ces couches 56, 58 sont collées directement l'une sur l'autre. Dans ces conditions, dans la position fléchie, les couches 56 et 58 entraînent l'apparition de charges de même signe, par exemple positives, sur les faces extérieure et intérieure de la membrane 54.

Ici, le matériau piézoélectrique présente un coefficient de couplage k supérieur à 5% ou 10%. Ce coefficient de couplage est défini dans la norme ANSI/IEEE 176-1987 « ANSI/IEEE Standard on Piezoelectricity » ou dans les normes de la famille EN 50-324. Plus précisément, ici le matériau piézoélectrique utilisé présente un coefficient piézoélectrique g₃₁ supérieur à 5 x 10⁻³Vm/N et, de préférence, supérieur à 10 x 10⁻³Vm/N ou 100 x 10⁻³Vm/N ou 200 x 10⁻³Vm/N à 25° C. Ici, le matériau piézoélectrique est du PZT (Titano-Zyrconate de Plomb) ou du PMN-PT (lead magnésium niobate-lead titanate) ou encore du PVDF (Polyfluorure de Vinylidène). Dans ce dernier cas, l'épaisseur des couches en PVDF sera de préférence inférieure à 300 µm ou 100 µm ou 10 µm.

Une électrode 60 est déposée sur la face extérieure de la membrane 54. L'électrode 60 est réalisée dans un matériau électriquement conducteur. Ici, par matériau électriquement conducteur, on désigne un matériau dont la résistivité à 25° C est inférieure à 10⁻⁵ Ω.m et de préférence inférieure à 10⁻⁶ Ω.m ou 10⁻⁷ Ω.m. L'électrode 60 est directement déposée sur la face extérieure de la membrane 54. Typiquement, elle recouvre la majorité de cette face extérieure et, de préférence, plus de 70 % ou 80 % de cette face extérieure (figure 5). Ici, l'électrode 60 est réalisée à l'aide d'une couche d'un seul tenant en matériau électriquement conducteur qui recouvre la majorité de la face extérieure de la membrane 54. Plus précisément, dans ce mode de réalisation, l'électrode 60 forme un anneau entourant l'arbre 8.

Dans la position de repos, la couche 52 s'étend dans un plan horizontal appelé « plan de référence ». Elle est réalisée, au moins en partie, dans un matériau magnétostrictif. Ici, par « matériau magnétostrictif », on désigne un matériau dont la valeur absolue du coefficient de magnétostriction λₛ à saturation est supérieure à 10 ppm (partie par million) et, de préférence, supérieure à 100 ou 1000 ppm. Le coefficient λₛ est défini par la relation suivante : λₛ = ΔL/L, où :
- ΔL est le taux d'élongation du matériau magnétostrictif le long d'une direction donnée, et
- L est la longueur de ce matériau dans cette direction en absence de champ magnétique extérieur.

Dans ce mode de réalisation, le coefficient λₛ est positif. Par exemple, le matériau magnétostrictif est le Terfenol-D ou le FeSiB ou un alliage de FeCo. La couche 52 est décrite plus en détail en référence à la figure 5.

Dans le cas particulier décrit ici, la couche 52 est également électriquement conductrice. Dans ces conditions, la couche 52 remplit également la fonction d'électrode intérieure pour la membrane 54.

Ici, la couche 52 est directement déposée et collée sur un substrat 62. Le substrat 62 est un substrat non magnétique, c'est-à-dire ne présentant pas de propriété magnétique mesurable dans les conditions d'utilisation du générateur 2. Il forme avec cette couche 52 un bilame qui se tord en flexion, entre les positions fléchie et moins fléchie représentées sur les figures 3 et 4, quand la couche 52 s'allonge radialement. Typiquement, l'amplitude du débattement maximal entre ses positions fléchie et moins fléchie est supérieure à l'épaisseur de la membrane 54. A cet effet, par exemple, on ajuste la rigidité en flexion de la couche 52 et de la membre 54 de façon appropriée. La rigidité en flexion d'une couche est ajustée en choisissant le matériau et/ou l'épaisseur de la couche par exemple. Par la suite, par « rigidité en flexion » d'une couche, on désigne le produit du module de Young de cette couche par son épaisseur. La rigidité en flexion est également appelée « rigidité flexionnelle » ou « résistance à la flexion ». Dans ce mode de réalisation, pour obtenir la déformation en flexion souhaitée du convertisseur 20, les matériaux de la couche 52 et de la membrane 54 ainsi que leurs épaisseurs sont choisis de manière à ce que la relation suivante soit vérifiée : E_{f}*t_{f} > α*Eₛ*tₛ, où :
- E_{f} est le module de Young à 25°C de la couche 52,
- t_{f} est l'épaisseur de la couche 52,
- Eₛ est le module de Young à 25°C du substrat 62,
- tₛ est l'épaisseur de la membrane 62,
- α est une constante strictement supérieure à un et, de préférence, supérieure à 10, 20 ou 100.

A titre d'illustration, on donne ci-dessous différents matériaux possibles pour réaliser le substrat 62 et la valeur de leur module de Young à 25°C :

| **Matériau** | **Module de Young (GPa)** |
|---|---|
| Silicium | 190 |
| Clinquant Acier | 200 |
| Clinquant Laiton | 60 |
| Plexiglass | 3 |

Toujours à titre d'illustration, le module de Young à 25°C du Terfenol-D ou d'un alliage de NiTi est typiquement de 150 GPa.

Ici, la rigidité en flexion de la membrane 54 est très inférieure à la rigidité en flexion du bilame formé par l'assemblage de la couche 52 et du substrat 62. Par « très inférieure », on désigne ici le fait que E_{M}*t_{M} est cent ou mille fois inférieure à E_{f}*t_{f}, où :
- E_{M} est le module de Young à 25°C de la membrane 54, et
- t_{M} est l'épaisseur de la membrane 54.

A titre d'illustration, on rappelle que E_{M} vaut environ 50 GPa pour du PZT céramique et environ 3 GPa pour du PVDF et similaire. Ainsi, la couche 54 ne limite quasiment pas la déformation en flexion de ce bilame.

La figure 6 représente plus en détail la structure de la couche 52. La couche 52 est un disque de même rayon que la membrane 54. Elle comporte quatre blocs 70 à 73 s'étendant le long de deux axes horizontaux se coupant sur l'axe 9. L'angle entre ces axes horizontaux est choisi égal à l'angle existant entre les directions des moments magnétiques de l'ensemble 12 à plus ou moins 10° ou 5° près et, de préférence, à plus ou moins 2° près. Sur la figure 6, la couche 52 est représentée dans une première position particulière où les blocs 70 à 73 s'étendent, respectivement, le long des axes 48 et 50 orthogonaux entre eux. Plus précisément, les blocs 70 et 72 sont alignés sur l'axe 48 tandis que les blocs 71 et 73 sont alignés sur l'axe 50.

Les blocs 70 à 73 sont réalisés dans le même matériau magnétostrictif. De plus, chaque bloc 70 à 73 présente son propre axe préférentiel de déformation. L'axe préférentiel de déformation d'un bloc est l'axe le long duquel l'amplitude de sa déformation est maximale lorsqu'il est traversé par des lignes de champ parallèles à cet axe.

Pour certain matériau mégnétostrictif, lorsque les lignes de champ saturent magnétiquement le bloc magnétostrictif, l'axe préférentiel de déformation est parallèle à ces lignes de champ. Dans cette situation, l'axe préférentiel de déformation est imposé par la disposition du bloc magnétostrictif par rapport à la source de ces lignes de champ. Lorsque le bloc en matériau magnétostrictif n'est pas saturé magnétiquement, l'axe préférentiel de déformation peut aussi être une propriété intrinsèque du bloc qui est due, par exemple, à l'orientation cristalline du matériau magnétostrictif et/ou au facteur de forme du bloc. Ici, par « facteur de forme », on désigne le rapport de la longueur sur la largeur du rectangle horizontale de plus petite surface à l'intérieur duquel est contenu le bloc.

Ici, typiquement, le facteur de forme de chaque bloc est strictement supérieure à 1 ou 1,5 ou 2 et l'axe préférentiel de déformation est parallèle à sa longueur. Ainsi, dans les modes de réalisation décrits ci-dessous, à défaut d'indication contraire, l'axe préférentiel de déformation de chaque bloc est systématiquement confondu avec son axe longitudinal.

Ici, chaque bloc 70 à 73 est rectangulaire. Ils sont tous situés dans le plan de référence.

De plus, dans ce mode de réalisation, la couche 52 comprend aussi une partie centrale traversée par l'arbre 8.

Ici, le bloc 72 est le symétrique du bloc 70 par rapport à l'axe 9. De même, le bloc 73 est le symétrique du bloc 71 par rapport à cet axe 9. De plus, le bloc 71 est identique au bloc 70 à l'exception du fait qu'il est décalé angulairement de 90° par rapport à ce bloc 70.

Dans la première position, chaque bloc 70 à 73 est en vis-à-vis d'un aimant 42 à 45 respectif. Par exemple, dans cette première position, pour chaque bloc 70 à 73, la surface de l'intersection entre les projections orthogonales sur le plan de référence de ce bloc et d'un aimant permanent respectif de l'ensemble 12 est supérieure ou égale à plus de 50 % et, de préférence, à plus de 80 % ou 90 % de la surface de ce bloc dans ce plan. Dans ces conditions, on dit que ce bloc est situé à l'intérieur de la projection orthogonale de l'aimant permanent. Par la suite, cette même définition est utilisée pour définir ce que l'on entend par le fait qu'un élément est en vis-à-vis d'un aimant permanent.

Dans ce mode de réalisation, la couche 52 comporte également quatre régions 76 à 79 dépourvues de matériau magnétostrictif et intercalées entre les blocs 70 à 73. Les bords latéraux de ces blocs 70 à 73 sont donc mécaniquement séparés des bords latéraux des autres blocs immédiatement adjacents par ces quatre régions 76 à 79.

La région 76 est délimitée d'un côté par un bord latéral du bloc 70 et de l'autre côté par un bord latéral du bloc 71. Sa périphérie extérieure est alignée avec un bord vertical des couches 54 et 58. Les régions 77, 78 et 79 sont identiques à la région 76 sauf qu'elles sont décalées angulairement autour de l'axe 9, respectivement, de 90°, 180° et 270°. Ainsi, dans ce mode de réalisation, chaque région a essentiellement la forme d'un secteur angulaire dont l'angle au sommet est égal à 90°. L'épaisseur de chacune de ces régions 76 à 79 est égale à l'épaisseur des blocs 70 à 73. Dans la première position, ces régions sont situées en dehors des projections orthogonales des aimants permanents de l'ensemble 12. On considère qu'un élément est situé en dehors de la projection orthogonale d'un aimant permanent s'il n'est pas en vis-à-vis de cet aimant permanent avec la définition donnée ci-dessus.

Le fonctionnement du générateur 2 va maintenant être décrit. Dans la première position représentée sur la figure 6, les blocs 70 à 73 sont traversés par des lignes de champ parallèles à leur axe préférentiel respectif de déformation. En réponse, la déformation, ici l'allongement, des blocs 70 à 73 est maximale. Dans le même temps, le substrat 62 ne s'allonge pas. Par conséquent, le bilame formé par la superposition de la couche 52 et du substrat 62 se fléchit se qui rapproche les points d'ancrage 55 les uns des autres. Dans le même temps cela déplace la membrane 54 de sa position de repos vers sa position fléchie. Dès lors, dans cette première position, des charges électriques de même signe sont générées sur quasiment la totalité des faces de la membrane 54, ce qui accroît l'énergie électrique produite par le convertisseur 20. Cette excédent de charges électriques est collecté par le circuit 30 et transmis au condensateur 32.

Lorsque le convertisseur 20 fait 1/8 de tour autour de l'axe 9 depuis la première position, une seconde position est atteinte. Dans cette seconde position, les blocs 70 à 73 sont situés à mi-distance entre deux aimants consécutifs de l'ensemble 12. Les directions des moments magnétiques de l'ensemble 12 sont donc décalées angulairement de 45° par rapport aux axes préférentiels de déformation des blocs 70 à 73. Dans cette seconde position, ce sont les régions 76 à 79 qui sont en vis-à-vis des aimants 42 à 45. Puisque ces régions 76 à 79 sont dépourvues de matériau magnétostrictif, les blocs 70 à 73 ne tendent plus à s'allonger mais, au contraire, ils se rétrécissent simultanément pour ramener la membrane 54 vers sa position de repos. Ainsi, dans cette seconde position, les contraintes mécaniques exercées par les blocs 70 à 73 sur la membrane 54 sont minimales.

La figure 7 représente l'agencement d'une couche transductrice 110 susceptible d'être utilisée à la place de la couche 52 dans le convertisseur 20. Ici, le nombre d'axes préférentiels de déformation de la couche transductrice est égal à trois. Plus précisément, la couche 110 est identique à la couche 52, sauf qu'elle comporte trois blocs 116 à 118 qui s'étendent, respectivement, le long d'axes 112 à 114. Ici, ces axes 112 à 114 sont décalés angulairement les uns par rapport aux autres de 120° de sorte que le décalage angulaire entre ces axes est uniformément réparti autour de l'axe 9. Dans ce mode de réalisation, le matériau magnétostrictif de la couche 110 présente une forme de « Y ».

Lorsque la couche 110 est utilisée, l'ensemble 12 est remplacé par un ensemble d'aimants permanents agencés les uns par rapport aux autres pour qu'il existe au moins une position dans laquelle chacun de ces aimants est en vis-à-vis d'un bloc respectif de la couche 110. De plus ces trois aimants permanents sont agencés pour présenter simultanément trois moments magnétiques horizontaux dont les décalages angulaires entre eux sont identiques aux décalages angulaires existant entre les axes 112 à 114. Pour simplifier la figure 7, seule la projection orthogonale de ces trois moments magnétiques sur le plan de référence est représentée par trois flèches en gras. Avec un tel ensemble d'aimants permanents, le fonctionnement d'un convertisseur incorporant la couche 110 est identique au fonctionnement décrit pour le convertisseur 20. Toutefois, la seconde position où la membrane 54 est dans sa position de repos est atteinte après une rotation de 60° autour de l'axe 9 depuis la première position représentée sur la figure 7.

La figure 8 représente une couche transductrice 120 susceptible d'être utilisée à la place de la couche 52 dans le convertisseur 20. Cette couche 120 est identique à la couche 52 sauf que les blocs 70 à 73 sont remplacés par des blocs 126 à 129. Ces blocs 126 à 129 sont par exemple identiques, respectivement, aux blocs 70 à 73. Dans la première position représentée sur la figure 8, les blocs 126 à 129 sont donc en vis-à-vis, respectivement, des aimants permanents 42 à 45.

Dans ce mode de réalisation, les régions qui séparent les blocs 126 à 129 comportent chacune, respectivement, un bloc 134 à 137 en matériau magnétostrictif différent de celui utilisé pour réaliser les blocs 126 à 129. Plus précisément, les blocs 134 à 137 sont réalisés dans un matériau magnétostrictif dont le coefficient λₛ de magnétostriction est de signe opposé au matériau magnétostrictif utilisé pour réaliser les blocs 126 à 129. Par exemple, il s'agit ici du SamFeNol qui est un alliage de Samarium à coefficient de magnétostriction négatif.

Ici, l'agencement des blocs 134 et 136 est identique à l'agencement des blocs 126 et 128, sauf qu'ils sont décalés angulairement de +45° autour de l'axe 9. De même, l'agencement des blocs 135 et 137 est le même que celui des blocs 126 et 128 sauf qu'ils sont décalés angulairement de -45° autour de l'axe 9. Ainsi, les blocs 134 et 136 sont alignés sur un axe horizontal 140 incliné de +45° par rapport à l'axe 48 et les blocs 135 et 137 sont alignés sur un axe horizontal 142 incliné de -45° par rapport à l'axe 48. Les axes préférentiels de déformations des blocs 134 et 136 sont alignés sur l'axe 140 tandis que les axes préférentiels de déformation des blocs 135 et 137 sont alignés sur l'axe 142.

La couche 120 est conçue pour fonctionner avec l'ensemble 12 d'aimants permanents. Les blocs 126 à 129 fonctionnent comme décrit en référence aux figures 1 à 6. Toutefois, dans la seconde position, les blocs 134 à 137 se retrouvent en vis-à-vis des aimants 42 à 45. Dans cette seconde position, les axes préférentiels de déformation des blocs 134 à 137 sont alignés avec les moments magnétiques de l'ensemble 12. Dès lors, les blocs 134 à 137 se rétrécissent ce qui déplace la membrane 54 dans une autre position fléchie en sens inverse de celle représentée sur la figure 4. Ainsi, dans cette seconde position, presque la totalité de la surface intérieure de la membrane 54 est soumise à une contrainte en tension. Cela permet donc d'augmenter l'amplitude entre les différences de potentiels produites dans les première et seconde positions par rapport au mode de réalisation de la figure 1 et donc d'augmenter l'efficacité du convertisseur.

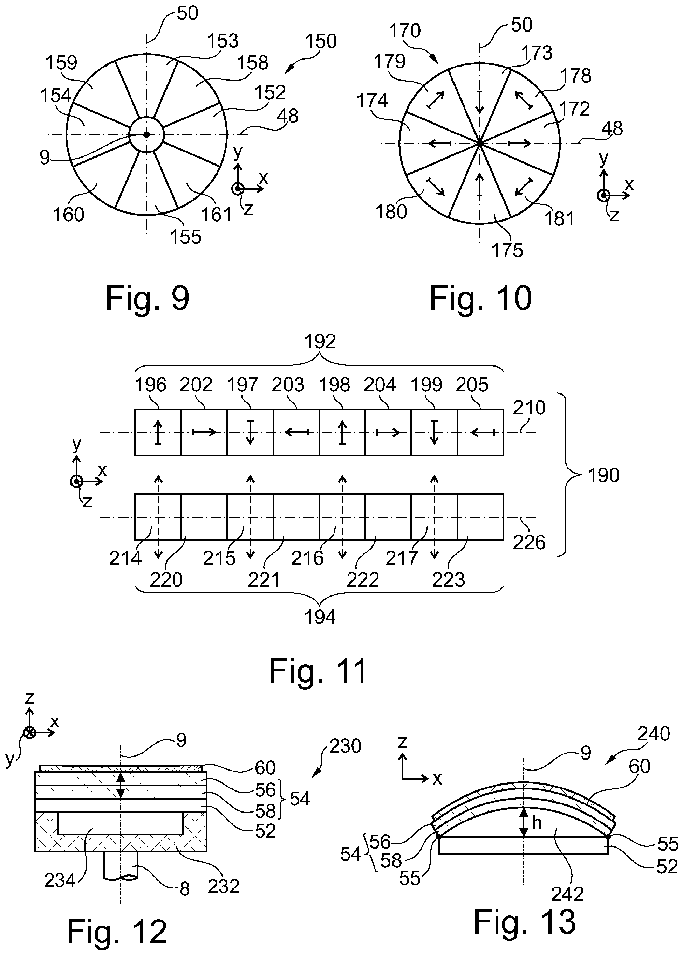

La figure 9 représente, dans une première position, une couche transductrice 150 susceptible d'être utilisée à la place de la couche 52 dans le convertisseur 20. Cette couche 150 est identique à la couche 52 sauf que les blocs 70 à 73 sont remplacés par des blocs 152 à 155. Dans la première position, les blocs 152, 154 s'étendent le long de l'axe 48 et les blocs 153, 155 s'étendent le long de l'axe 50. Les axes longitudinaux des blocs 152 à 155 sont alignés sur les axes le long desquels ils s'étendent. Le bloc 152 a essentiellement la forme d'un secteur angulaire dont le sommet est situé sur l'axe 9 et dont la bissectrice est confondue avec l'axe 48 dans la première position. L'angle au sommet du bloc 152 est égal à 45°. Ici, le sommet de ce secteur angulaire est supprimé pour laisser un passage pour l'arbre 8. Les blocs 153 à 155 sont identiques au bloc 152 sauf qu'ils sont décalés angulairement autour de l'axe 9 par rapport au bloc 52 de, respectivement, 90°, 180° et 270°. Avec ce choix de la valeur de l'angle au sommet du bloc 152, les régions 158 à 161 dépourvues de matériau magnétostrictif sont aussi des secteurs angulaires de même forme que le bloc 152 mais décalées angulairement autour de l'axe 9, respectivement, de 45°, 135°, 225° et 315° par rapport à la position du secteur angulaire du bloc 152.

La figure 10 représente un ensemble 170 d'aimants permanents destiné à remplacer l'ensemble 12 lorsque la couche 52 est remplacée par la couche 150. L'ensemble 170 est identique à l'ensemble 12 sauf que les aimants permanents 42 à 45 sont remplacés par, respectivement, des aimants permanents 172 à 175. Les aimants 172 à 175 ont chacun la même forme que les blocs 152 à 155 et sont agencés les uns par rapport aux autres comme décrit pour les blocs 152 à 155. Toutefois, le sommet du secteur angulaire de chaque aimant n'a pas été supprimé pour laisser un passage pour l'arbre 8. Ainsi, dans la première position, chaque bloc 152 à 155 est en vis-à-vis d'un aimant 172 à 175 respectif. Les directions des moments magnétiques des aimants 172 et 174 sont alignées sur l'axe 48. A l'inverse, les directions des moments magnétiques des aimants 173 et 175 sont alignées sur l'axe 50.

En vis-à-vis des régions 158 à 161, dans la première position, l'ensemble 170 comporte des aimants permanents supplémentaires, respectivement, 178 à 181. Chacun de ces aimants 178 à 181 à la même forme que l'aimant 172. Ces aimants 178 à 181 sont décalés angulairement autour de l'axe 9 de, respectivement, 45°, 135°, 225° et 315° par rapport à la position de l'aimant 172. Ainsi, après une rotation de 45° de la couche 150 pour atteindre une seconde position, chaque bloc 152 à 155 se trouve en vis-à-vis d'un aimant 178 à 181 respectif.

La direction des moments magnétiques des aimants 178 à 181 est choisie pour que les lignes de champ magnétique qu'ils génèrent à l'intérieur des blocs 152 à 155 dans la seconde position soient tournées de 90°, dans un plan horizontal, par rapport aux lignes de champs magnétique que génèrent les aimants 172 à 175 à l'intérieur de ces mêmes blocs mais dans la première position. Pour cela, la direction du moment magnétique de chaque aimant 178 à 181 est perpendiculaire à la bissectrice du secteur angulaire occupé par cet aimant et dont l'angle au sommet est situé sur l'axe 9.

Lors du fonctionnement de la couche 150, dans la première position, les blocs 152 à 155 s'allongent radialement et la membrane 54 atteint sa position fléchie représentée sur la figure 4. Dans la seconde position, les blocs 152 à 155 sont en vis-à-vis cette fois-ci des aimants 178 à 181. Dans cette seconde position, les lignes de champs magnétiques qui traversent les blocs 152 à 155 sont perpendiculaires aux axes longitudinaux de ces blocs. Des lors dans la seconde position, chaque bloc 152 à 155 s'allonge dans la direction des lignes de champ qui le traversent ce qui correspond à un rétrécissement dans la direction horizontale perpendiculaire à son axe longitudinal. Le bilame formé par la couche 150 et le substrat 62 se fléchit alors en sens inverse et la membrane 54 est déplacée vers une position moins fléchie dans laquelle elle est incurvée en sens inverse. Cela permet donc d'augmenter l'amplitude entre les différences de potentiels produites dans les première et seconde positions.

Les modes de réalisation décrits jusqu'à présent, l'ont été dans le cas particulier où le convertisseur tourne par rapport à l'ensemble d'aimants permanents. Toutefois, tout ce qui a été décrit dans ce contexte particulier, s'applique également au cas où l'ensemble d'aimants permanents se déplace en translation par rapport au convertisseur parallèlement au plan de référence. Pour passer d'un mode de réalisation à l'autre, il suffit de « dérouler » les structures décrites dans le cas d'un mouvement rotatif pour obtenir le mode de réalisation correspondant dans le cas d'un mouvement de translation.

Par exemple, la figure 11 représente un générateur 190 correspondant au mode de réalisation des figures 9 et 10 mais avec un mouvement de translation. Pour simplifier la figure 11, seules les principaux éléments qui diffèrent par rapport au générateur 2 sont représentés. Plus précisément, dans le générateur 190, l'ensemble 12 est remplacé par un ensemble 192 d'aimants permanents et la couche 52 est remplacée par une couche 194. La couche 194 est interposée entre une membrane piézoélectrique et un substrat non magnétique similaires, respectivement, à la membrane 54 et au substrat 62. Sur la figure 11, l'ensemble 192 et la couche 194 sont représentés en vue de dessus et l'un à côté de l'autre. Dans la réalité, l'ensemble 192 et la couche 194 sont superposés verticalement l'un au-dessus de l'autre.

L'ensemble 192 comprend quatre aimants permanents 196 à 199 et quatre aimants permanents 202 à 205. Tous ces aimants sont alignés sur un même axe 210 parallèle à la direction X. Les aimants 202 à 204 sont interposés entre, respectivement, les aimants 196, 197, les aimants 197, 198 et les aimants 198, 199. L'aimant 205 est accolé, sur la droite, à l'aimant 199. Les aimants 196 à 199 ont chacun un moment magnétique uni-axial parallèle à la direction Y. Les aimants 202 à 205 ont chacun un moment magnétique uni-axial parallèle à la direction X. Tous les aimants ont la même largeur dans la direction X.

La couche 194 comporte quatre blocs 214 à 217 dans le même matériau magnétostrictif séparés par quatre régions 220 à 223 dépourvues de matériau magnétostrictif. Ces blocs et régions sont tous alignés sur un axe 226 parallèle à la direction X. Plus précisément, les régions 220 à 222 sont interposées entre, respectivement, les blocs 214, 215, les blocs 215, 216 et les blocs 216, 217. La région 223 est ici accolée sur la droite du bloc 223. Cette région 223 peut aussi être omise. Les axes préférentiels de déformation des blocs 214 à 217 sont parallèles à la direction Y.

L'ensemble 192 et la couche 194 sont déplaçables l'un par rapport à l'autre entre une première position, représentée sur la figure 11, et une seconde position. Dans la seconde position, la couche 194 est décalée d'un pas vers la gauche, dans la direction X, par rapport à la première position. Ici, ce pas est égal à la largeur d'un aimant permanent de l'ensemble 192.

Dans la première position, les blocs 214 à 217 sont situés en vis-à-vis des aimants 196 à 199 et les régions 220 à 223 sont situées en vis-à-vis des aimants 202 à 205. Dans la seconde position, ce sont les régions 220 à 223 qui sont situées en vis-à-vis des aimants 196 à 199 et les blocs 215 à 217 qui sont situés en vis-à-vis des aimants 202 à 204. Dans cet exemple, dans la seconde position, le bloc 214 n'est en vis-à-vis d'aucun élément.

Dans l'agencement décrit, les aimants 196 à 199 correspondent fonctionnellement aux aimants 172 à 175 et les aimants 202 à 205 correspondent fonctionnellement aux aimants 178 à 181. De même, les blocs 214 à 217 correspondent fonctionnellement aux blocs 152 à 155 et les régions 220 à 223 correspondent fonctionnellement aux régions 158 à 155. Ainsi, le fonctionnement du générateur 190 se déduit du fonctionnement de la couche 150 avec l'ensemble 170 sauf qu'ici la génération d'électricité est provoquée par un déplacement en translation selon la direction X de la couche 194 par rapport à l'ensemble 192 et non pas par un mouvement de rotation.

La figure 12 représente un convertisseur 230. Ce convertisseur 230 est identique au convertisseur 20 sauf que le substrat 62 est remplacé par un substrat 232. Le substrat 232 est identique au substrat 62 sauf qu'il comporte une cavité 234 aménagée entre la face inférieure de la couche 52 et la face supérieure du substrat 232. Cette cavité est centrée autour de l'axe vertical 9. De plus, dans la figure 12, le convertisseur 230 est monté à l'extrémité de l'arbre 8. Par conséquent, dans ce mode de réalisation et dans les modes de réalisation suivants, l'arbre 8 ne traverse par le convertisseur. Le fonctionnement du convertisseur 230 se déduit des explications données pour le convertisseur 20.

La figure 13 représente un convertisseur 240 identique au convertisseur 20 sauf que :
- le substrat 62 est omis,
- les points d'ancrage 55 entre la membrane 54 et la couche 52 sont uniquement situés sur la périphérie extérieure de la membrane 54 et de la couche 52, et
- la membrane 54 est pré-contrainte pour qu'elle soit dans sa position fléchie en absence de champ magnétique.

Ici, la périphérie extérieure de la couche 52 et de la membrane 54 est un cercle horizontal dont le centre est situé sur l'axe 9. Cette périphérie regroupe l'ensemble des extrémités de la membrane 54 les plus éloignées de l'axe 9. A chaque extrémité de la membrane 54 située sur sa périphérie extérieure correspond une autre extrémité également située sur sa périphérie extérieure, mais du côté diamétralement opposé par rapport à l'axe 9.

Dans ce mode de réalisation, dans la position fléchie, une partie centrale de la couche 52 située entre les points d'ancrage 55 est séparée de la membrane 54 par un espace creux 242. Typiquement, la hauteur maximale de cet espace 242 dans la direction verticale est supérieure, et de préférence dix ou cent ou mille fois supérieur, à l'épaisseur de la membrane 54. Cette hauteur maximale correspond à la flèche de la membrane 54.

La figure 14 représente le convertisseur 240 lorsque la membrane 54 est dans sa position moins fléchie. Cette position moins fléchie est atteinte lorsque le convertisseur 20 est dans sa première position par rapport à l'ensemble 12 d'aimants. Dans cette première position, l'allongement de la couche 52 est maximal. Cela éloigne donc les points 55 les uns des autres et déplace la membrane 54 vers sa position moins fléchie. Dans cet exemple, dans sa position moins fléchie, l'espace 242 a disparu et la membrane 54 s'étend horizontalement le long de la partie centrale de la couche 52. La couche 52 ne fléchie pas ou seulement de façon négligeable car la rigidité en flexion de la membrane 54 est au moins deux ou dix fois ou 100 fois inférieure à la rigidité en flexion de cette couche 52.

Les figures 15 et 16 représentent un convertisseur 250 susceptible d'être utilisé à la place du convertisseur 230. Ce convertisseur 250 comporte un châssis 252 dans lequel est ancrée, sans aucun degré de liberté, la périphérie extérieure de la membrane 54.

Dans le convertisseur 250, la couche 52 est séparée de la face intérieure de la membrane 54 par une cavité 254. La couche 52 est également fixée sur le châssis 252 par l'intermédiaire d'une liaison glissière qui immobilise la couche 52 dans la direction Z, mais qui lui permet de s'allonger et de se rétrécir dans les directions horizontales X et Y. Par exemple, la périphérie de la couche 52 est en appui glissant sur des faces horizontales et planes du châssis 252.

Dans ce mode de réalisation, la couche 52 est mécaniquement raccordée à la membrane 54 par l'intermédiaire de bras tendus logés à l'intérieur de la cavité 254. Plus précisément, ces bras sont mécaniquement raccordés, d'un côté, à un point milieu 256 et, de l'autre côté, à des points d'ancrage respectifs situés sur la couche 52. Le point milieu 256 est situé à intersection entre la face intérieure de la membrane 54 et de l'axe 9. Ici, le point milieu 256 sert de point de fixation des bras sur la membrane 54. Les points d'ancrage sont situés sur la couche 52 uniquement à proximité des extrémités distales des blocs 70 à 73 les plus éloignées de l'axe 9.

Le substrat 62 est omis.

Sur la figure 15, seuls deux bras 258 et 259 sont visibles. Le bras 258 s'étend entre le point milieu 256 et un point d'ancrage 262, tandis que le bras 259 s'étend entre le point milieu 256 et un point d'ancrage respectif 263. Les points d'ancrage 262 et 263 sont diamétralement opposés par rapport à l'axe 9.

La figure 15 représente le convertisseur 250 dans la situation où la couche 52 est dans la seconde position par rapport à l'ensemble 12 d'aimants. Dans cette position, les blocs 70 à 73 et les points d'ancrage 262, 263 sont dans la position rapprochée, et la membrane 54 s'étend sensiblement horizontalement.

La figure 16 représente le convertisseur 250 lorsque la couche 52 est dans sa première position par rapport à l'ensemble 12 d'aimants permanents. Dans cette position, les points d'ancrage 262, 263 sont dans leur position éloignée les uns des autres. Les bras 258 et 259 sont ici suffisamment rigides en tension pour ne pas s'allonger quand la couche 52 s'allonge. Dans ces conditions, parce que les points d'ancrage 262 et 263 s'éloignent du point milieu 256, les bras 258 et 259 tirent verticalement vers le bas ce point milieu 256, et la membrane 54 fléchit de sa position moins fléchie vers sa position fléchie. On remarquera que dans ce mode de réalisation, les bras 258 et 259 travaillent en tension et non pas en compression. Par conséquent, ils n'ont pas besoin d'être rigides en compression.

La couche 52 se déforme presque uniquement dans un plan horizontal, tandis que la membrane 54 se déforme en flexion car la rigidité en flexion de la membrane 54 est très inférieure à celle de la couche 52.

La figure 17 représente un convertisseur 270. Ce convertisseur 270 comporte un châssis 272 auquel est fixé, sans degré de liberté, seulement le centre de la face extérieure de la membrane 54. Le centre de cette face extérieure est situé sur l'axe 9.

Des points de fixation sont réalisés sur la périphérie extérieure de la face intérieure de la membrane 54. Les points de fixation sont situés sur des extrémités diamétralement opposées de la membrane 54. Chaque point de fixation est aussi placé en vis-à-vis d'un point d'ancrage respectif situé sur l'extrémité distale d'un bloc respectif de la couche 52. Sur la figure 17, seuls des points de fixation 274 et 275 diamétralement opposés sont visibles sur la face intérieure. Ces points de fixation 274 et 275 sont en vis-à-vis, respectivement, de points d'ancrage 276 et 277 situés sur la couche 52. Chaque point d'ancrage de la couche 52 est mécaniquement attaché à un point de fixation situé sur la face intérieure de la membrane 54 par des bras rigides en tension, c'est-à-dire des bras qui ne s'allongent pas quand la couche 52 s'allonge.

Ici, les points d'ancrage 276 et 277 sont diamétralement opposés par rapport à l'axe 9.

Sur la figure 17, seuls deux bras 280 et 281 ont été représentés. Le bras 280 raccorde mécaniquement le point 276 au point 275, tandis que le bras 281 raccorde mécaniquement le point 277 au point 274.

Quand la couche 52 s'allonge, les points 277 et 276 s'éloignent l'un de l'autre. Par conséquent, les bras 280 et 281 tirent simultanément vers le bas les points 274 et 275 situés sur la membrane 54. Ainsi, en réponse, la membrane 54 se fléchit de manière à ce que sa périphérie extérieure soit plus proche de la couche 52 que dans la position représentée sur la figure 17. En effet, le centre de la couche 54 est maintenu immobile par le châssis 272 et la rigidité en flexion de la couche 52 est très supérieure à celle de la membrane 54.

Dans ce mode de réalisation, lorsque les points d'ancrage sont dans leur position rapprochée, la membrane 54 est dans sa position moins fléchie. A l'inverse, lorsque les points d'ancrage sont dans leur position éloignée, la membrane 54 est dans sa position fléchie.

La figure 18 représente un couche transductrice 300 destinée à remplacer la couche 52 lorsque la variation d'énergie à récupérer est une variation de température. La couche 300 est ici identique à la couche 52 sauf que les blocs 70 à 73 sont remplacés, respectivement, par des blocs 301 à 304. Dans ce mode de réalisation, les blocs 301 à 304 sont identiques aux blocs 70 à 73 sauf qu'ils sont réalisés dans un matériau à mémoire de forme. L'axe préférentiel de déformation des blocs 301 et 303 est parallèle, dans la première position représentée sur la figure 18, à l'axe 48. Dans cette première position, l'axe préférentiel de déformation des blocs 302 et 304 est parallèle à l'axe 50. Comme dans le cas des blocs en matériau magnétostrictif, l'axe préférentiel de déformation est ici l'axe le long duquel l'amplitude de la déformation est maximale en réponse à une variation donnée de température. De plus, comme pour les blocs en matériau magnétostrictif, lorsque le bloc en matériau à mémoire de forme se contracte le long de son axe préférentiel de déformation, il s'allonge simultanément le long d'un axe horizontal perpendiculaire. Chaque bloc 301 à 304 est ici configurée pour qu'en réponse à une augmentation de la température extérieure, il se contracte le long de son axe préférentiel de déformation et, simultanément, s'allonge le long d'un autre axe perpendiculaire. Toutefois, dans le cas des matériaux à mémoire de forme, la direction de l'axe préférentiel de déformation est une caractéristique intrinsèque du bloc configurée lors de sa fabrication. Ainsi, la direction de l'axe préférentiel de déformation des blocs 301 à 304 ne dépend pas de leur position relative par rapport à la source d'énergie à récupérer. Ici, le matériau à mémoire de forme présente un taux d'allongement, le long de son axe préférentiel de déformation, supérieur à 0,5% ou 1 % en réponse à une variation de température de 10° ou de 20°C. Pour plus d'informations sur les matériaux à mémoire de forme utilisables dans un tel convertisseur, il est possible de se référer à l'article A1.

Dans le cas où la couche 300 est utilisée dans le convertisseur, l'ensemble 12 d'aimants permanents est remplacé par un ensemble 310 de sources locales de chaleur représenté sur la figure 16. L'ensemble 310 comporte deux sources locales 312 et 314 de chaleur. Les sources 312 et 314 s'étendent uniquement le long, respectivement, des axes 48 et 50 de manière à chauffer essentiellement les blocs en vis-à-vis de ces axes tout en chauffant beaucoup moins les régions qui ne sont pas en vis-à-vis de ces axes. Par exemple, dans cette première position, pour chaque bloc 301 à 304, la surface de l'intersection entre les projections orthogonales sur le plan de référence de ce bloc et de la source en vis-à-vis de l'ensemble 310 est supérieure ou égale à plus de 30 % ou 50 % et, de préférence, à plus de 80 % ou 90 % de la surface de ce bloc dans ce plan. A titre d'illustration, les sources 312 et 314 sont des tuyaux parcourus par un fluide caloporteur. Les sources 312 et 314 peuvent aussi être des filaments ou des résistances chauffantes. Dans ce mode de réalisation, comme la couche 300 tourne par rapport à l'ensemble 310, la température des sources 312 et 314 est, par exemple, constante. Les blocs 301 à 304 sont chauffés quand ils se trouvent en vis-à-vis des sources 312 et 314 et se refroidissent quand ils sont en vis-à-vis des régions 76 à 79. Le fonctionnement du générateur équipé de la couche 300 et de l'ensemble 310 se déduit des explications données en référence aux figures 1 à 6.

De nombreux autres modes de réalisation sont possibles. Par exemple, une couche supplémentaire pré-contrainte peut être collée sur l'une des faces de la membrane piézoélectrique pour que cette membrane soit incurvée même en absence de variations de l'énergie à récupérer. Si dans sa position de repos, la membrane est fléchie, alors en réponse à une variation de l'énergie à récupérer, la flexion de la membrane peut augmenter ou au contraire diminuer. Cela permet donc notamment de générer entre les bornes 22 et 24, tantôt une différence de potentiel positive, tantôt une différence de potentiel négative.

Quel que soit le mode de réalisation précédemment décrit, les extrémités de la membrane piézoélectrique peuvent être fixées, non pas directement au point d'ancrage, mais par l'intermédiaire de bras mécaniques tels que les bras 280 et 281 précédemment décrits.

La membrane 54 n'est pas nécessairement formée de deux couches piézoélectriques. En variante, l'une des couches 56, 58 est omises. A l'inverse, des couches supplémentaires en matériau piézoélectrique peuvent être ajoutées.

La couche piézoélectrique de la membrane 54 n'est pas non plus nécessairement en un seul bloc. Par exemple, elle peut aussi être réalisée par l'accolement les uns à côté des autres de plusieurs blocs en matériau piézoélectrique. Toutefois même dans ce cas, les différents blocs de la couche piézoélectrique sont fixés les uns aux autres sans aucun degré de liberté de manière à se comporter mécaniquement comme un seul bloc de matière. Typiquement, dans ce cas, tous les blocs de matériau piézoélectrique sont polarisés dans le même sens.

D'autres matériaux piézoélectrique peuvent être utilisés. Par exemple, le matériau piézoélectrique peut être une mousse piézoélectrique telle que l'une de celles décrites dans l'article suivant : Imran Patel, « Ceramic based intelligent piezoelectric energy harversting device », Intechopen, 6 septembre 2011.

La membrane 54 en matériau piézoélectrique peut présenter d'autres formes. Par exemple, avantageusement, elle peut également être conformée en forme d'ellipse plutôt que de disque. La section horizontale de cette membrane 54 peut également, en variante, être carrée ou rectangulaire ou être un polygone à plus de cinq sommets.

Le nombre de blocs de la couche transductrice et le nombre de sources d'énergie à récupérer peut être supérieur à quatre, huit ou douze. Ce nombre peut être très grand notamment dans le cas d'un déplacement linéaire comme décrit en référence à la figure 11. De préférence, si le déplacement entre les première et seconde positions se fait par rotation, alors le nombre de blocs est inférieur à douze. De plus, lorsque le déplacement entre les première et seconde positions se fait par rotation, de préférence, les blocs et les sources sont uniformément réparties autour de l'axe de rotation.

Le nombre de blocs peut aussi être égal à un. Dans ce cas, le bloc et la membrane sont par exemple rectangulaires.

Les différents blocs de la couche transductrice ne s'étendent pas nécessairement dans le même plan. Dans ce cas, le plan de référence est le plan médian aux différents plans dans lesquels s'étendent ces différents blocs et l'on considère la projection orthogonale d'un bloc sur ce plan de référence pour savoir si celui-ci est situé à l'intérieur de la projection orthogonale d'une source.

Un matériau magnétostrictif à coefficient de magnétostriction négatif peut être utilisé à la place d'un matériau magnétotrictif à coefficient de magnétostriction positif. Par exemple, il peut s'agir du SamFeNol qui est un alliage de Samarium à coefficient de magnétostriction négatif. Dans ce cas la membrane 54 se fléchit en sens inverse par rapport à ce qui a été décrit dans le cas d'un matériau magnétostrictif à coefficient de magnétostriction positif.

Le matériau magnétostrictif peut aussi être remplacé par un alliage à mémoire de forme magnétique tel que le NiMnGa, c'est-à-dire un matériau qui travaille comme décrit pour les précédents matériaux à mémoire de forme sauf que la déformation est déclenchée par une variation du champ magnétique et non pas par une variation de température.

En variante, les points d'ancrage ne sont pas nécessairement situés sur les extrémités des blocs de la couche transductrice. Par exemple, ces blocs peuvent s'étendre au-delà des points d'ancrage même si, en pratique, ce n'est pas nécessaire pour déplacer les points d'ancrage.

La forme de la membrane et de la couche transductrice n'est pas nécessairement circulaire. Par exemple, cette membrane et cette couche peuvent être rectangulaires. Dans ce cas, les points d'ancrage sont de préférence situés sur les petits côtés de la couche transductrice.

Si la rigidité en flexion de la membrane 54 est inférieure à la rigidité en flexion de la couche 52, alors le substrat 62 peut être omis.

Le substrat 62 peut aussi être placé ailleurs que directement collé sous la couche 62. Par exemple, le substrat 62 peut être interposé entre les deux couches 56, 58 ou entre la membrane 54 et la couche 52. La membrane 52 peut aussi être placée entre les deux couches 56, 58. Dans ce cas, lorsque la couche 56 subit une contrainte en tension, la couche 58 subit une contrainte en compression et vice versa.

L'électrode 60 n'a pas besoin d'être formée d'un seul bloc de matière. En variante, l'électrode 60 comprend plusieurs plots conducteurs répartis sur la face extérieure de la membrane 54 et séparés mécaniquement les uns des autres par des tranchées remplies d'un matériau électriquement isolant, des conducteurs électriques raccordant en série ces différents plots.

En variante, une électrode intérieure en matériau électriquement conducteur est interposée entre la couche 52 et la membrane 54. Cela s'avère nécessaire dans tout mode de réalisation où la couche transductrice est réalisée dans un matériau qui n'est pas électriquement conducteur ou dans les modes de réalisation où la couche 52 est électriquement isolée de la face intérieure de la membrane 54.

Les électrodes extérieures ne sont pas nécessairement directement fixées sur la membrane piézoélectrique. Par exemple, elles peuvent être séparées de cette membrane par une fine couche intermédiaire isolante dont l'épaisseur est inférieure à un centième ou un millième de l'épaisseur de la membrane. Elles peuvent également être légèrement mobiles par rapport à la couche en matériau piézoélectrique.

Chaque aimant permanent peut être réalisé dans un seul bloc de matière. Chaque aimant permanent peut aussi être composé d'un empilement les unes sur les autres de plusieurs lames aimantées, chaque lame de l'empilement présentant un moment magnétique parallèle à celui des autres lames de cet empilement. Le sens du moment magnétique d'une lame par rapport à celui des autres lames du même empilement n'a pas d'importance car le matériau magnétostrictif est uniquement sensible à la direction du moment magnétique et non pas à son sens.

L'ensemble 12 peut être réalisé sans utiliser d'aimants permanents. Par exemple, il peut être réalisé en utilisant des bobines parcourues par un courant.

Les aimants permanents de l'ensemble 12 peuvent être disposés dans un plan qui n'est pas nécessairement horizontal. Dans une autre variante, les directions des moments magnétiques des sources de l'ensemble ne sont pas toutes coplanaires.

L'aimant 46 peut être omis.

Les différents modes de réalisation précédemment décrits peuvent être combinés. Par exemple, l'ensemble 170 peut être utilisé avec la couche 120.

Il est possible d'adapter tous les modes de réalisation précédemment décrits dans le cas particulier de blocs en matériau magnétostrictif à la récupération d'une variation de température en remplaçant ces blocs magnétostrictifs par des blocs réalisés en matériau à mémoire de forme. De plus, dans le cas des blocs en matériau à mémoire de forme, il est possible de faire varier la température de ces blocs sans déplacer la couche 300 par rapport à des sources locales de chaleur. Pour cela, par exemple, l'ensemble 310 est remplacé par une source de chaleur capable de chauffer de la même manière et simultanément l'ensemble des blocs 301 à 304 et dont la température varie au cours du temps.

Plusieurs convertisseurs 20 centrés sur l'axe 9 peuvent être empilés les uns au dessus des autres dans la direction verticale.

Le convertisseur peut également être monté au bout de l'arbre 8 de sorte que la membrane piézoélectrique et la couche transductrice ne sont pas traversées par cet arbre 8.

Le mouvement relatif de l'ensemble 12 par rapport au convertisseur 20 peut également être obtenu en fixant l'ensemble 12 sans aucun degré de liberté sur l'extrémité de l'axe 8 et en fixant le convertisseur 20 sur le châssis immobile 14.

L'appareil 10 peut être un roulement mécanique. Dans ce cas, l'axe 8 est l'axe de ce roulement et le châssis 14 est le châssis du roulement.

## Revendications

1. Convertisseur d'une variation d'énergie à récupérer en une différence de potentiels entre deux bornes de raccordement, la variation d'énergie à récupérer étant une variation de champ magnétique ou de température, ce convertisseur comportant :
- une membrane piézoélectrique (54) présentant :
• des faces intérieure et extérieure parallèles,
• au moins deux extrémités diamétralement opposées par rapport à un plan perpendiculaire à ses faces intérieure et extérieure, et passant par le centre de gravité de la membrane piézoélectrique, et
• un point milieu (256) situé à mi-distance entre les extrémités diamétralement opposées,
- des première et seconde électrodes (60) en matériau électriquement conducteur s'étendant essentiellement le long d'au moins une face de la membrane piézoélectrique pour faire apparaître un excédent de charges électriques sur l'une de ces électrodes en réponse à la déformation de la membrane piézoélectrique,
- une couche transductrice (52) s'étendant entre des points d'ancrage (262, 263; 276, 277), cette couche transductrice étant apte à transformer la variation d'énergie à récupérer en un déplacement mécanique des points d'ancrage les uns par rapport aux autres entre une position éloignée, dans laquelle les points d'ancrage sont éloignés les uns des autres, et une position rapprochée dans laquelle les points d'ancrage sont plus rapprochés les uns des autres, chacun de ces points d'ancrage étant attaché à un point de fixation situé sur la membrane piézoélectrique pour déformer cette membrane piézoélectrique en flexion de façon réversible entre une position fléchie et une position moins fléchie lorsque ces points d'ancrage se déplacent, l'amplitude du débattement maximal entre ses positions fléchie et moins fléchie étant supérieur à l'épaisseur de la membrane piézoélectrique, et
- un châssis (252 ; 272),
**caractérisé en ce que** :
- l'un seulement des extrémités de la membrane et du point milieu est fixé, sans aucun degré de liberté, dans le châssis, et
- le convertisseur comporte, entre chaque point d'ancrage (262, 263; 276, 277) et le point de fixation auquel il est attaché, un bras rigide (258, 259 ; 280, 281), tendu entre ce point d'ancrage et ce point de fixation, ce bras étant apte à transformer le déplacement des points d'ancrage en un déplacement qui déforme la membrane piézoélectrique entre ses positions fléchie et moins fléchie,
le point de fixation étant situé sur le point milieu lorsque les extrémités de la membrane piézoélectrique sont fixées, sans aucun degré de liberté, dans le châssis et le point de fixation (274, 275) étant situé sur une extrémité respective de la membrane piézoélectrique lorsque le point milieu est fixé, sans aucun degré de liberté, dans le châssis.

2. Le convertisseur selon la revendication 1, dans lequel les matériaux de la couche transductrice (52) et de la membrane piézoélectrique (54) ainsi que leurs épaisseurs vérifient : E_{M}*t_{M} est cent fois inférieure à E_{f}*t_{f}, où :
- E_{M} est le module de Young à 25°C de la membrane piézoélectrique,
- t_{M} est l'épaisseur de la membrane piézoélectrique,
- E_{f} est le module de Young à 25°C de la couche transductrice,
- t_{f} est l'épaisseur de la couche transductrice.

3. Le convertisseur selon la revendication 1, dans lequel la couche transductrice (300) comporte plusieurs blocs (301-304) en matériau à mémoire de forme séparés les uns des autres par des régions (76-79) dépourvues de tel bloc, chaque bloc présentant un axe préférentiel de déformation le long duquel l'amplitude de sa déformation est maximale lorsqu'il est chauffé, ces blocs étant agencés les uns par rapport aux autres de manière à ce que les axes préférentiels de déformation des différents blocs se coupent en un même point central et soient uniformément répartis autour de ce point central, les points d'ancrage étant placés sur les extrémités de chacun de ces blocs situés du côté opposé au point central.

4. Le convertisseur selon la revendication 3, dans lequel le nombre de blocs (301-304) uniformément répartis autour du point central est supérieur à trois.

5. Le convertisseur selon la revendication 1, dans lequel le convertisseur comporte un bras (258, 259) rigide, tendu entre chaque point d'ancrage (262, 263) et le point milieu (256) de la membrane piézoélectrique, ce bras étant apte à transformer le déplacement des points d'ancrage en un déplacement du point milieu le long d'une direction perpendiculaire aux faces de la membrane piézoélectrique et ainsi déformer la membrane piézoélectrique entre ses positions fléchie et moins fléchie.

6. Le convertisseur selon l'une quelconque des revendications 1 à 4, dans lequel, lorsque le point milieu est fixé sans aucun degré de liberté dans le châssis, le point de fixation du bras (280, 281) est située sur l'extrémité de la membrane piézoélectrique diamétralement opposée, c'est-à-dire l'extrémité opposée à l'extrémité de la membrane piézoélectrique la plus proche du point d'ancrage à partir duquel s'étend ce bras.

7. Le convertisseur selon la revendication 6, dans lequel chaque point de fixation (274, 275) est placé en vis-à-vis d'un point d'ancrage respectif (276, 277) et chaque point d'ancrage de la couche transductrice (52) est mécaniquement attaché à un point de fixation situé sur une face intérieure de la membrane piézoélectrique (54) par des bras rigides en tension, c'est-à-dire des bras qui ne s'allongent pas quand la couche transductrice (52) s'allonge.

8. Générateur d'électricité comprenant :
- un convertisseur (20 ; 190) d'une variation d'énergie à récupérer en une différence de potentiels entre deux bornes électriques, la variation d'énergie à récupérer étant une variation de champ magnétique ou de température, et
- un ensemble (12 ; 170 ; 192 ; 310) de plusieurs premières sources (42-45 ; 172-175 ; 312, 314) d'énergie à récupérer fixées les unes aux autres sans aucun degré de liberté, chaque première source générant localement de l'énergie à récupérer, **caractérisé en ce que** :
- le convertisseur est conforme à l'une quelconque des revendications précédentes et la couche transductrice comporte plusieurs premiers blocs (70-73; 116-118; 126-129; 152-155; 214-217; 301-304) en matériau magnétostrictif ou à mémoire de forme et, intercalées entre des bords latéraux de ces premiers blocs, des régions (76-79 ; 200-222) dépourvues de premier bloc, et
- au moins l'un de l'ensemble et du convertisseur est déplaçable en alternance, à l'intérieur du plan de référence, entre :
• une première position dans laquelle les premiers blocs sont disposés en vis-à-vis d'une première source respective d'énergie à récupérer, et
• une seconde position dans laquelle les régions sont disposées en vis-à-vis d'une première source respective et chaque premier bloc est situé à mi-distance entre deux premières sources.

9. Générateur selon la revendication 8, dans lequel :
- les premiers blocs (70-73 ; 116-118 ; 126-129 ; 152-155 ; 214-217) sont réalisés en matériau magnétostrictif et ont des coefficients de magnétostriction de même signe,
- les premières sources sont des sources (42-45 ; 172-175) de champ magnétique fixées les unes aux autres sans aucun degré de liberté, chaque première source étant apte, dans la première position, à générer à l'intérieur du premier bloc en vis-à-vis, des lignes de champ parallèles au plan de référence et à un axe préférentiel de déformation de ce premier bloc.

10. Générateur selon la revendication 9, dans lequel l'ensemble comporte en plus des secondes sources (178-181 ; 202-205) de champ magnétique, intercalées entre les premières sources (182-175 ; 196-199), ces secondes sources étant en vis-à-vis d'un premier bloc respectif dans la seconde position, chaque seconde source étant apte, dans la seconde position, à générer à l'intérieur du premier bloc en vis-à-vis des lignes de champ parallèle au plan de référence et perpendiculaire, à plus ou moins 10° près, à l'axe préférentiel de déformation de ce premier bloc.

11. Générateur selon la revendication 9 ou 10, dans lequel la couche transductrice comporte des seconds blocs (134-137) en matériau magnétostrictif intercalés entre les bords latéraux des premiers blocs (126-129), chaque second bloc étant situé, dans la seconde position, en vis-à-vis d'une première source respective de champ magnétique, les coefficients de magnétostriction des seconds blocs étant de signe opposé aux coefficients de magnétostriction des premiers blocs.

12. Générateur selon l'une quelconque des revendications 9 à 11, dans lequel chaque source de champ magnétique comporte au moins un aimant permanent.

13. Générateur selon la revendication 8, dans lequel :
- les premiers blocs (301-304) sont réalisés en matériau à mémoire de forme, chaque bloc présentant un axe préférentiel de déformation le long duquel l'amplitude de sa déformation est maximale en réponse à une variation de température,
- les premières sources sont des sources (312, 314) de chaleur fixées les unes aux autres sans aucun degré de liberté, chaque première source étant apte, dans la première position, à chauffer le premier bloc en vis-à-vis plus que les régions situées de part et d'autre de ce premier bloc.

14. Générateur selon l'une quelconque des revendications 8 à 13, dans lequel l'ensemble (12; 170; 192; 312, 314) de sources est déplaçable en rotation, par rapport au convertisseur, autour d'un axe (9) de rotation perpendiculaire au plan de référence pour passer entre les première et seconde positions, et les premières sources sont uniformément réparties autour de l'axe de rotation.

15. Générateur selon l'une quelconque des revendications 10 à 13, dans lequel l'ensemble (192) de sources est déplaçable en translation, par rapport au convertisseur, le long d'un axe (210) de translation parallèle au plan de référence pour passer entre les première et seconde positions, et les premières sources sont uniformément réparties le long de cet axe de translation.

## Patentansprüche

1. Wandler einer Änderung zu gewinnender Energie in eine Potentialdifferenz zwischen zwei Anschlussklemmen, wobei die Änderung zu gewinnender Energie eine Magnetfeld- oder Temperaturänderung ist, wobei dieser Wandler aufweist:
- eine piezoelektrische Membran (54), die aufweist:
• parallele Innen- und Außenseiten,
• mindestens zwei Enden diametral entgegengesetzt bezüglich einer Ebene lotrecht zu ihren Innen- und Außenseiten und durch den Schwerpunkt der piezoelektrischen Membran verlaufend, und
• einen Mittenpunkt (256), der sich auf halber Strecke zwischen den diametral entgegengesetzten Enden befindet,
- erste und zweite Elektroden (60) aus elektrisch leitendem Material, die sich hauptsächlich entlang mindestens einer Seite der piezoelektrischen Membran erstrecken, um einen Überschuss elektrischer Ladungen an einer dieser Elektroden als Reaktion auf die Verformung der piezoelektrischen Membran auftreten zu lassen,
- eine Wandlerschicht (52), die sich zwischen Verankerungspunkten (262, 263; 276, 277) erstreckt, wobei diese Wandlerschicht die Änderung zu gewinnender Energie in eine mechanische Verschiebung der Verankerungspunkte zueinander zwischen einer entfernten Stellung, in der die Verankerungspunkte voneinander entfernt sind, und einer angenäherten Stellung umwandeln kann, in der die Verankerungspunkte einander näher sind, wobei jeder dieser Verankerungspunkte mit einem Befestigungspunkt verbunden ist, der sich auf der piezoelektrischen Membran befindet, um diese piezoelektrische Membran umkehrbar zwischen einer gebogenen Stellung und einer weniger gebogenen Stellung in Biegung zu verformen, wenn diese Verankerungspunkte sich verschieben, wobei die Größe des maximalen Ausschlags zwischen ihren gebogenen und weniger gebogenen Stellungen größer als die Dicke der piezoelektrischen Membran ist, und
- ein Gestell (252; 272),
**dadurch gekennzeichnet, dass**:
- nur eines von den Enden der Membran und dem Mittenpunkt ohne jeden Freiheitsgrad im Gestell befestigt ist, und
- der Wandler zwischen jedem Verankerungspunkt (262, 263; 276, 277) und dem Befestigungspunkt, mit dem er verbunden ist, einen steifen Arm (258, 259; 280, 281) aufweist, der zwischen diesem Verankerungspunkt und diesem Befestigungspunkt gespannt ist, wobei dieser Arm die Verschiebung der Verankerungspunkte in eine Verschiebung umwandeln kann, die die piezoelektrische Membran zwischen ihrer gebogenen Stellung und ihrer weniger gebogenen Stellung verformt,
wobei der Befestigungspunkt sich auf dem Mittenpunkt befindet, wenn die Enden der piezoelektrischen Membran ohne jeden Freiheitsgrad im Gestell befestigt sind, und der Befestigungspunkt (274, 275) sich auf einem jeweiligen Ende der piezoelektrischen Membran befindet, wenn der Mittenpunkt ohne jeden Freiheitsgrad im Gestell befestigt ist.

2. Wandler nach Anspruch 1, wobei die Materialien der Wandlerschicht (52) und der piezoelektrischen Membran (54) sowie ihre Dicken erfüllen: E_{M}*t_{M} ist hundert Mal kleiner als E_{f}*t_{f}, wobei:
- E_{M} der Young-Modul bei 25°C der piezoelektrischen Membran ist,
- t_{M} die Dicke der piezoelektrischen Membran ist,
- E_{f} der Young-Modul bei 25°C der Wandlerschicht ist,
- t_{f} die Dicke der Wandlerschicht ist.

3. Wandler nach Anspruch 1, wobei die Wandlerschicht (300) mehrere Blöcke (301-304) aus Material mit Formgedächtnis aufweist, die voneinander durch Bereiche (76-79) getrennt sind, die keinen solchen Block haben, wobei jeder Block eine bevorzugte Verformungsachse aufweist, entlang der die Größe seiner Verformung maximal ist, wenn er erwärmt wird, wobei diese Blöcke so zueinander angeordnet sind, dass die bevorzugten Verformungsachsen der verschiedenen Blöcke sich in einem gleichen zentralen Punkt schneiden und gleichmäßig um diesen zentralen Punkt herum verteilt sind, wobei die Verankerungspunkte auf den Enden jedes dieser Blöcke angeordnet sind, die sich auf der dem zentralen Punkt entgegengesetzten Seite befinden.

4. Wandler nach Anspruch 3, wobei die Anzahl von gleichmäßig um den zentralen Punkt herum verteilten Blöcken (301-304) größer als drei ist.

5. Wandler nach Anspruch 1, wobei der Wandler einen steifen Arm (258, 259) aufweist, der zwischen jedem Verankerungspunkt (262, 263) und dem Mittenpunkt (256) der piezoelektrischen Membran gespannt ist, wobei dieser Arm die Verschiebung der Verankerungspunkte in eine Verschiebung des Mittenpunkts entlang einer Richtung lotrecht zu den Seiten der piezoelektrischen Membran umwandeln und so die piezoelektrische Membran zwischen ihrer gebogenen und weniger gebogenen Stellung verformen kann.

6. Wandler nach einem der Ansprüche 1 bis 4, wobei, wenn der Mittenpunkt ohne jeden Freiheitsgrad im Gestell befestigt ist, der Befestigungspunkt des Arms (280, 281) sich auf dem diametral entgegengesetzten Ende der piezoelektrischen Membran befindet, d.h. dem Ende entgegengesetzt zu dem Ende der piezoelektrischen Membran, das dem Verankerungspunkt am nächsten ist, von dem aus sich dieser Arm erstreckt.

7. Wandler nach Anspruch 6, wobei jeder Befestigungspunkt (274, 275) gegenüber einem jeweiligen Verankerungspunkt (276, 277) angeordnet ist, und jeder Verankerungspunkt der Wandlerschicht (52) durch steife unter Spannung stehende Arme mechanisch mit einem Befestigungspunkt verbunden ist, der sich auf einer Innenseite der piezoelektrischen Membran (54) befindet, d.h. Arme, die sich nicht verlängern, wenn die Wandlerschicht (52) sich verlängert.

8. Stromgenerator, der enthält:
- einen Wandler (20; 190) einer Änderung zu gewinnender Energie in eine Potentialdifferenz zwischen zwei elektrischen Anschlüssen, wobei die Änderung zu gewinnender Energie eine Magnetfeld- oder Temperaturänderung ist, und
- eine Einheit (12; 170; 192; 310) mehrerer erster Quellen (42-45; 172-175; 312, 314) zu gewinnender Energie, die ohne jeden Freiheitsgrad aneinander befestigt sind, wobei jede erste Quelle lokal zu gewinnende Energie erzeugt,
**dadurch gekennzeichnet, dass**:
- der Wandler einem der vorhergehenden Ansprüche entspricht und die Wandlerschicht mehrere erste Blöcke (70-73; 116-118; 126-129; 152-155; 214-217; 301-304) aus Magnetwiderstandsmaterial oder Material mit Formgedächtnis und zwischen Seitenrändern dieser ersten Blöcke Bereiche (76-79; 200-222) ohne ersten Block aufweist, und
- mindestens eines von der Einheit und dem Wandler abwechselnd innerhalb der Bezugsebene verschiebbar ist zwischen:
• einer ersten Stellung, in der die ersten Blöcke gegenüber einer ersten Quelle zu gewinnender Energie angeordnet sind, und
• einer zweiten Stellung, in der die Bereiche gegenüber einer ersten Quelle angeordnet sind und jeder Block sich auf halber Strecke zwischen zwei ersten Quellen befindet.

9. Generator nach Anspruch 8, wobei:
- die ersten Blöcke (70-73; 116-118; 126-129; 152-155; 214-217) aus Magnetwiderstandsmaterial hergestellt sind und Magnetostriktionskoeffizienten gleichen Vorzeichens haben,
- die ersten Quellen Magnetfeldquellen (42-45; 172-175) sind, die ohne jeden Freiheitsgrad aneinander befestigt sind, wobei jede erste Quelle in der ersten Stellung im Inneren des gegenüberliegenden ersten Blocks Feldlinien parallel zur Bezugsebene und zu einer bevorzugten Verformungsachse dieses ersten Blocks erzeugen kann.

10. Generator nach Anspruch 9, wobei die Einheit außerdem zweite Magnetfeldquellen (178-181; 202-205) aufweist, die zwischen die ersten Quellen (182-175; 196-199) eingefügt sind, wobei diese zweiten Quellen einem jeweiligen ersten Block in der zweiten Stellung gegenüberliegen, wobei jede zweite Quelle in der zweiten Stellung im Inneren des gegenüberliegenden ersten Blocks Feldlinien parallel zur Bezugsebene und bis auf mehr oder weniger 10° lotrecht zur bevorzugten Verformungsachse dieses ersten Blocks erzeugen kann.

11. Generator nach Anspruch 9 oder 10, wobei die Wandlerschicht zweite Blöcke (134-137) aus Magnetwiderstandsmaterial aufweist, die zwischen die Seitenränder der ersten Blöcke (126-129) eingefügt sind, wobei jeder zweite Block sich in der zweiten Stellung gegenüber einer jeweiligen ersten Magnetfeldquelle befindet, wobei die Magnetostriktionskoeffizienten der zweiten Blöcke ein den Magnetostriktionskoeffizienten der ersten Blöcke entgegengesetztes Vorzeichen haben.

12. Generator nach einem der Ansprüche 9 bis 11, wobei jede Magnetfeldquelle mindestens einen Dauermagnet aufweist.

13. Generator nach Anspruch 8, wobei:
- die ersten Blöcke (301-304) aus Material mit Formgedächtnis hergestellt sind, wobei jeder Block eine bevorzugte Verformungsachse aufweist, entlang der die Größe seiner Verformung als Reaktion auf eine Temperaturänderung maximal ist,
- die ersten Quellen Wärmequellen (312, 314) sind, die ohne jeden Freiheitsgrad aneinander befestigt sind, wobei jede erste Quelle in der ersten Stellung den gegenüberliegenden ersten Block mehr erwärmen kann als die Bereiche, die sich zu beiden Seiten dieses ersten Blocks befinden.

14. Generator nach einem der Ansprüche 8 bis 13, wobei die Einheit (12; 170; 192; 312, 314) von Quellen bezüglich des Wandlers um eine Drehachse (9) lotrecht zur Bezugsebene in Drehung verschiebbar ist, um zwischen der ersten und der zweiten Stellung überzugehen, und die ersten Quellen gleichmäßig um die Drehachse verteilt sind.

15. Generator nach einem der Ansprüche 10 bis 13, wobei die Einheit (192) von Quellen bezüglich des Wandlers entlang einer Translationsachse (210) parallel zur Bezugsebene in Translation verschiebbar ist, um zwischen der ersten und der zweiten Stellung überzugehen, und die ersten Quellen gleichmäßig entlang dieser Translationsachse verteilt sind.

## Claims

1. Converter of a variation of energy to be harvested into a potential difference between two connection terminals, the variation of energy to be harvested being a variation of magnetic field or of temperature, this converter comprising:
- a piezoelectric membrane (54) having:
• parallel inner and outer faces,
• at least two ends diametrically opposed relative to a plane at right angles to its inner and outer faces, and passing through the center of gravity of the piezoelectric membrane, and
• a mid-point (256) situated mid-way between the diametrically opposed ends,
- first and second electrodes (60) of electrically conductive material extending essentially along at least one face of the piezoelectric membrane to reveal an excess of electrical charges on one of these electrodes in response to the deformation of the piezoelectric membrane,
- a transducer layer (52) extending between anchoring points (262, 263; 276, 277), this transducer layer being suitable for transforming the variation of energy to be harvested into a mechanical displacement of the anchoring points relative to one another between a distant position, in which the anchoring points are distant from one another, and a close position in which the anchoring points are closer to one another, each of these anchoring points being attached to a fixing point situated on the piezoelectric membrane to deform this piezoelectric membrane by bending reversibly between a bent position and a less bent position when these anchoring points are displaced, the amplitude of the maximum travel between its bent and less bent positions being greater than the thickness of the piezoelectric membrane, and
- a frame (252; 272),
**characterized in that**:
- only one of the ends of the membrane and of the mid-point is fixed, without any degree of freedom, in the frame, and
- the converter comprises, between each anchoring point (262, 263; 276, 277) and the fixing point to which it is attached, a rigid arm (258, 259; 280, 281) tensioned between this anchoring point and this fixing point, this arm being suitable for transforming the displacement of the anchoring points into a displacement which deforms the piezoelectric membrane between its bent and less bent positions,
the fixing point being situated on the mid-point when the ends of the piezoelectric membrane are fixed, with no degree of freedom, in the frame and the fixing point (274, 275) being situated on a respective end of the piezoelectric membrane when the mid-point is fixed, with no degree of freedom, in the frame.

2. Converter according to Claim 1, in which the materials of the transducer layer (52) and of the piezoelectric membrane (54) and their thicknesses bear out: E_{M}^{*}t_{M} is one hundred times less than E_{f}*t_{f}, in which:
- E_{M} is the Young's modulus at 25° of the piezoelectric membrane,
- t_{M} is the thickness of the piezoelectric membrane,
- E_{f} is the Young's modulus at 25°C of the transducer layer,
- t_{f} is the thickness of the transducer layer.

3. Converter according to Claim 1, in which the transducer layer (300) comprises a number of blocks (301-304) of material with shape memory separated from one another by regions (76-79) without any such block, each block having a preferential axis of deformation along which the amplitude of its deformation is maximum when it is heated, these blocks being arranged relative to one another in such a way that the preferential axes of deformation of the different blocks intersect at a same central point and are uniformly distributed around this central point, the anchoring points being placed on the ends of each of these blocks situated on the side opposite the central point.

4. Converter according to Claim 3, in which the number of blocks (301-304) uniformly distributed around the central point is greater than three.

5. Converter according to Claim 1, in which the converter comprises a rigid arm (258, 259), tensioned between each anchoring point (262, 263) and the mid-point (256) of the piezoelectric membrane, this arm being suitable for transforming the displacement of the anchoring points into a displacement of the mid-point along a direction at right angles to the faces of the piezoelectric membrane and thus deform the piezoelectric membrane between its bent and less bent positions.

6. Converter according to any one of Claims 1 to 4, in which, when the mid-point is fixed with no degree of freedom in the frame, the fixing point of the arm (280, 281) is situated on the diametrically opposite end of the piezoelectric membrane, that is to say the end opposite the end of the piezoelectric membrane closest to the anchoring point from which this arm extends.

7. Converter according to Claim 6, in which each fixing point (274, 275) is placed facing a respective anchoring point (276, 277) and each anchoring point of the transducer layer (52) is mechanically attached to a fixing point situated on an inner face of the piezoelectric membrane (54) by tensioned rigid arms, that is to say arms which are not elongated when the transducer layer (52) is elongated.

8. Electricity generator comprising:
- a converter (20; 190) of a variation of energy to be harvested into a potential difference between two electric terminals, the variation of energy to be harvested being a variation of magnetic field or of temperature, and
- a set (12; 170; 192; 310) of a number of first sources (42-45; 172-175; 312, 314) of energy to be harvested fixed to one another with no degree of freedom, each first source locally generating energy to be harvested, **characterized in that**:
- the converter conforms to any one of the preceding claims and the transducer layer comprises a number of first blocks (70-73; 116-118; 126-129; 152-155; 214-217; 301-304) of magnetostrictive material or material with shape memory and, inserted between lateral edges of these first blocks, regions (76-79; 200-222) without any first block, and
- at least one of the set and of the converter can be displaced alternately, within the reference plane, between:
• a first position in which the first blocks are arranged facing a first respective source of energy to be harvested, and
• a second position in which the regions are arranged facing a first respective source and each first block is situated mid-way between two first sources.

9. Generator according to Claim 8, in which:
- the first blocks (70-73; 116-118; 126-129; 152-155; 214-217) are produced in magnetostrictive material and have magnetostriction coefficients of the same sign,
- the first sources are sources (42-45; 172-175) of magnetic field fixed to one another with no degree of freedom, each first source being suitable, in the first position, for generating, within the first block facing, field lines parallel to the reference plane and to a preferential axis of deformation of this first block.

10. Generator according to Claim 9, in which the set further comprises second sources (178-181; 202-205) of magnetic field, inserted between the first sources (182-175; 196-199), these second sources being facing a first respective block in the second position, each second source being suitable, in the second position, for generating, within the first block facing, field lines parallel to the reference plane and at right angles, to within plus or minus 10°, to the preferential axis of deformation of this first block.

11. Generator according to Claim 9 or 10, in which the transducer layer comprises second blocks (134-137) of magnetostrictive material inserted between the lateral edges of the first blocks (126-129), each second block being situated, in the second position, facing a first respective source of magnetic field, the magnetostriction coefficients of the second blocks being of a sign opposite the magnetostriction coefficients of the first blocks.

12. Generator according to any one of Claims 9 to 11, in which each source of magnetic field comprises at least one permanent magnet.

13. Generator according to Claim 8, in which:
- the first blocks (301-304) are produced in material with shape memory, each block having a preferential axis of deformation along which the amplitude of its deformation is maximum in response to a variation of temperature,
- the first sources are sources (312, 314) of heat fixed to one another with no degree of freedom, each first source being suitable, in the first position, for heating the first block facing more than the regions situated on either side of this first block.

14. Generator according to any one of Claims 8 to 13, in which the set (12; 170; 192; 312, 314) of sources can be displaced in rotation, relative to the converter, about an axis (9) of rotation at right angles to the reference plane to pass between the first and second positions, and the first sources are uniformly distributed about the axis of rotation.

15. Generator according to any one of Claims 10 to 13, in which the set (192) of sources can be displaced in translation, relative to the converter, along an axis (210) of translation parallel to the reference plane to pass between the first and second positions, and the first sources are uniformly distributed along this axis of translation.
